# EUROPÄISCHE PATENTSCHRIFT

(11) **EP 0 789 985 B1**
(45) Veröffentlichungstag und Bekanntmachung des Hinweises auf die Patenterteilung: **12.08.1998**
(21) Anmeldenummer: 95938386.0
(22) Anmeldetag: 02.11.1995
(51) Int. Cl.: H05K 7/18, H02B 1/38

(54) **SCHALTSCHRANK MIT EINEM RAHMENGESTELL**
SWITCHGEAR CABINET WITH FRAME
ARMOIRE DE DISTRIBUTION AVEC BAIE

(30) Priorität: 05.11.1994 DE 4439607
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: BENNER, Rolf, D-35745 Herborn (DE); NICOLAI, Walter, D-35418 Buseck (DE); STRACKBEIN, Heinrich, D-35444 Biebertal (DE)
(74) Vertreter: Fleck, Hermann-Josef, Dr.-Ing.
(86) Internationale Anmeldenummer: EP9504287
(87) Internationale Veröffentlichungsnummer: WO9614729

(56) Entgegenhaltungen:
- FR-A- 2 697 300
- US-A- 5 275 296

## Beschreibung

Die Erfindung betrifft einen Schaltschrank mit einem aus Rahmenschenkeln und Eckverbindern zusammengesetzten Rahmengestell, dessen offene Seiten mittels Seitenwänden, Rückwand, Bodenblech, Deckblech und mindestens einer Tür verschließbar bzw. verschlossen sind, und wobei zumindest die vertikalen Rahmenschenkel im Bereich ihrer Außenkanten abgeschrägt sind und dadurch eine Aufnahme für abgekantete Ränder der Seitenwände und der Tür bilden.

Ein solcher Schaltschrank ist aus der FR 2 697 300 bekannt. Bei diesen bekannten Schaltschränken bilden in der Regel zwei senkrecht zueinander stehende Profilseiten der Rahmenschenkel Außenseiten des Rahmengestelles und eine Außenkante desselben. Für die Anlenkung der Türe sind daher Scharnierelemente an den vertikalen Rahmenschenkeln anzubringen. Auf der Schließseite der Türe sind für die an der Türe angebrachten Schließeinrichtung zusätzlich Schließelemente anzubringen. Dabei ist oft die Anschlagseite der Türe am Rahmengestell festgelegt und kann am Einsatzort des Schaltschrankes nicht auf einfache Weise geändert werden. Außerdem liegt in der Regel auch fest, welche offene Seite des Rahmengestelles mit der Türe verschließbar sein soll.

Es ist Aufgabe der Erfindung, bei einem Schaltschrank der eingangs erwähnten Art ohne besondere Scharnier- und Schließelemente am Rahmengestell die Türe am Rahmengestell anzulenken, wobei die Anschlag- und Schließseite auf einfache Weise vertauscht werden kann und wobei die für eine Seite des Rahmengestelles vorgesehene Türe auch beliebig an der gegenüberliegenden Seite des Rahmengestelles angeschlagen werden kann.

Diese Aufgabe wird nach der Erfindung dadurch gelöst, daß die Eckverbinder die Aufnahmen der Rahmenschenkel überdecken und den Aufnahmen zugekehrt mit Steckaufnahmen bzw. Scharnierbolzen versehen sind, daß die Türe auf der Scharnierseite mit Scharnierbolzen bzw. Steckaufnahmen versehen ist, die in Steckaufnahmen der Eckverbinder einführbar bzw. eingeführt sind bzw. in die die Scharnierbolzen der Türe einführbar bzw. eingeführt sind, und daß die Türe auf der Schließseite mit Schließbolzen versehen ist, die mittels einer Schließeinrichtung in Steckaufnahmen der Eckverbinder einführbar und wieder herausführbar sind.

Bei dieser Ausgestaltung der Rahmenschenkel und Eckverbinder übernehmen die Eckverbinder auch die Funktionen, die für das Anlenken und Schließen der Türe erforderlich sind. Dazu sind an den Eckverbindern lediglich Steckaufnahmen bzw. Scharnierbolzen vorzusehen. Die Rahmenschenkel brauchen für die Türe keinerlei Scharnier- und Schließelemente mehr aufzuweisen. Die an den Rahmenschenkeln im Bereich der Außenkanten gebildeten Aufnahmen bieten ausreichend Platz, abgekantete Randabschnitte der Seitenwände und der Türe aufzunehmen.

Nach einer Ausgestaltung ist vorgesehen, daß die Rahmenschenkel zwei senkrecht zueinander stehende Profilseiten aufweisen, die Außenseiten des Rahmengestells bilden, und daß diese Profilseiten im Bereich der Außenkante über einen Verbindungs-Profilabschnitt miteinander verbunden sind, der jeweils unter 135° zu diesen Profilseiten steht. Bei dieser Ausgestaltung kann der Rahmenschenkel für beide anschließenden Seiten des Rahmengestelles als Scharnier- oder Schließseite einer Türe verwendet werden.

Die Aufnahme im Bereich der AußenKante der Rahmenschenkel kann dadurch vergrößert werden, daß die Profilseiten über senkrecht zu ihren stehende Übergangs-Profilabschnitte in den Verbindungsabschnitt übergehen.

Ist vorgesehen, das die Eckverbinder zwei senkrecht zueinander stehende Flächen aufweisen, die Teile der Außenkanten des Rahmengestelles bilden, und daß diese Flächen bündig mit den Außenseiten der angrenzenden Seitenwände und der geschlossenen Türe abschließen, dann wird in den Eckbereichen des Schaltschrankes ein bündiger Abschluß geschaffen.

Die Anbringung der Seitenwände, der Rückwand, des Bodenbleches und des Deckbleches erfolgt nach einer Ausgestaltung durcn Anschrauben an den Eckverbindern. Möglich ist auch eine Befestigung an den Rahmenschenkeln, ohne daß die Wandelemente mit Befestigungsbohrungen für Befestigungsschrauoen versehen sind.

Das Anbringen der Türe an dem Rahmengestell wird dadurch erleichtert, daß die Scharnierbolzen bzw. Schließbolzen in an der Türe angebrachten Lagerhülsen verstellbar geführt und/oder gehalten sind.

Die Anlenkung einer Türe kann auf einfache Weise auch dadurch erfolgen, daß die Scharnierbolzen durch Lagerhülsen der Türe geführt in Steckaufnahmen der Eckverbinder eingeführt und darin durch Paß- und/oder Preßsitz gehalten sind.

Die Erfindung wird anhand eines in den Zeichnungen dargestellten Ausführungsbeispiels näher erläutert. Es zeigen:
- Fig. 1: einen Teil eines Rahmengestelles mit dem vorderen, rechten Rahmenschenkel, an den eine Seitenwand und eine Türe angebracht werden, und
- Fig. 2: eine Teilansicht im Bereich des unteren Eckverbinders an dem vorderen, rechten Rahmenschenkel.

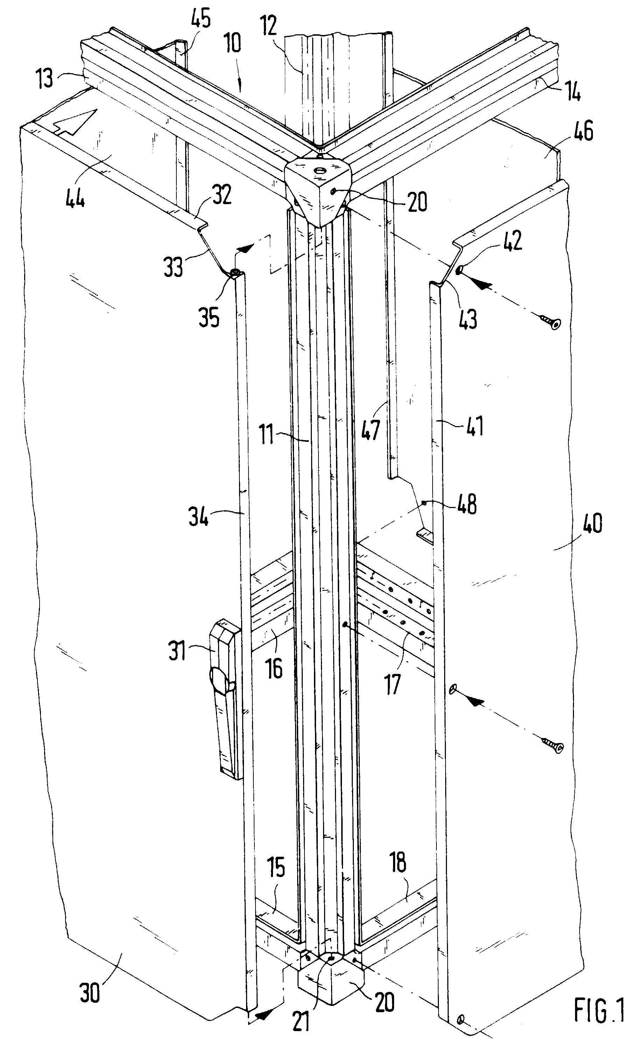

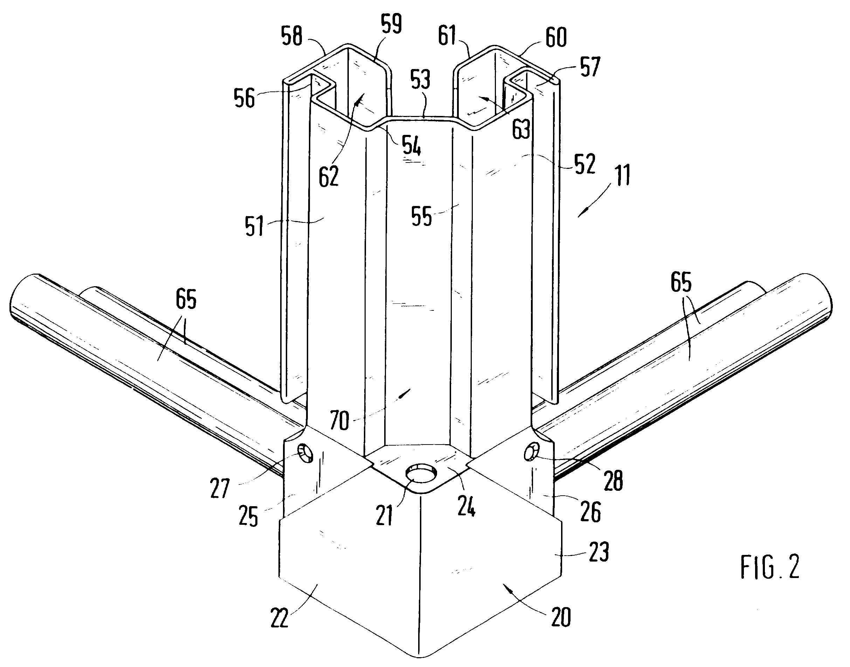

Von einem Rahmengestell 10 sind in Fig. 1 nur die vertikalen Rahmenschenkel 11 und 12 an der vorderen rechten Ecke und der hinteren linken Ecke zu erkennen. Am oberen Ende des vertikalen Rahmenschenkels 11 sind über einen Eckverbinder 20 die horizontalen Rahmenschenkel 13 und 14 angeschlossen. Im unteren Bereich sind die horizontalen Rahmenschenkel 15, 16, 17 und 18 gezeigt, von denen die Rahmenschenkel 15 und 18 über einen weiteren Eckverbinder 20 mit dem unteren Ende des vertikalen Rahmenschenkels 11 verbunden sind. Die Seitenwände 40 und 44 werden mit den Eckverbindern 20 verschraubt, wobei die Ecken abgeschrägt und ohne Ränder in diesen Bereichen versehen sind, wie die Ecke 43 der Seitenwand 40 erkennen läßt. Die Randabschnitte 41 und 45 der Seitenwände 40 und 44 ragen in Aufnahmen 70 der Rahmenschenkel. Wie Fig. 2 zeigt, sind die Rahmenschenkel im Bereich ihrer Außenkante abgeschrägt und bilden mit dem Verbindungsabschnitt 53 und den Übergangsabschnitten 54 und 55 eine Aufnahme 70. Der Eckverbinder 20 überdeckt mit einem Absatz 24 diese Aufnahme 70. Der Absatz 24 des Eckverbinders 20 trägt eine Steckaufnahme 21. Die senkrecht zueinander stehenden Flächen 22 und 23 der Eckverbinder 20 sind bündig mit den Außenseiten des Schaltschrankes, d.h. den Außenseiten der an den Eckverbindern 20 angebrachten Seitenwände 40 und 44, Rückwand 46 und Türe 30. Die Anlageflächen 25 und 26 für diese Teile sind um ihre Dicke gegenüber den Flächen 22 und 23 am Eckverbinder 20 zurückgesetzt, um die Bündigkeit zu erreichen. Zum Verschrauben sind die Anlageflächen 25 und 26 mit Gewindeaufnahmen 27 und 28 versehen.

Die Steckansätze 65 der Eckverbinder 20 sind in Aufnahmen 62 und 63 der Rahmenschenkel eingeführt und darin festgelegt. Diese Aufnahmen 62 und 63 werden durch mehrfach abgebogene Abschnitte 56, 58, 59 bzw. 57, 60, 61 begrenzt. Die dreifach abgebogenen Abschnitte 56 und 57 bilden nach außen offene Aufnahmenuten für Dichtungselemente. Diese Aufnahmenuten 56 und 57 liegen im Bereich der senkrecht zueinander stehenden Profilseiten 51 und 52, an denen die Seitenwände 40 und 44, die Rückwand 46, die Türe 30 und die nicht gezeigten Boden- und Deckbleche anliegen.

Zum Anschlagen der Türe 30 werden Scharnierbolzen verwendet, die z.B. in Lagerhülsen der Türe 30 verstell- und festlegbar sind. Beim Anschlagen der Türe 30 werden auf der Scharnierseite die zwei Scharnierbolzen in die Steckaufnahmen 21 der zwei zugeordneten Eckverbinder 20 eingeführt und in der eingeführten Stellung festgelegt.

Die Festlegung kann dabei in der Lagerhülse der Türe 30 oder in der Steckaufnahme 21 der Eckverbinder 20 erfolgen.

Haben die Seitenwände 40 und 44, die Rückwand 46 und die Türe 30 abgekantete Randabschnitte 41, 45, 47 bzw. 32 und 33, dann werden diese in den Aufnahmen 70 der Rahmenschenkel 11 bis 18 Platz finden.

Auf der Schließseite trägt die Türe 30 eine Schließeinrichtung 31, die z.B. als Schubstangenschloß ausgebildet sein kann. Die Schubstangen dienen als Schließbolzen 35 und sind in Lagerhülsen der Türe 30 verstellbar geführt und gehalten. Im Schließzustand der Schließeinrichtung 31 werden die Schubstangenenden als Schließbolzen 35 in die Steckaufnahmen 21 der angrenzenden Eckverbinder 20 eingeführt. Beim Öffnen der Schließeinrichtung 31 werden die Schubstangenenden aus den Steckaufnahmen 21 der Eckverbinder 20 herausgeführt und die auf der Scharnierseite angelenkte Türe 30 kann geöffnet werden.

Die Anbringung der Seitenwände, der Rückwand, des Bodenbleches und des Deckbleches kann auch mit von außen nicht sichtbaren Befestigungsmitteln erfolgen.

## Patentansprüche

1. Schaltschrank mit einem aus Rahmenschenkeln (11 bis 18) und Eckverbindern (20) zusammengesetzten Rahmengestell (10), dessen offene Seiten mittels Seitenwänden (40,44), Rückwand (46), Bodenblech, Deckblech und mindestens einer Tür (30) verschließbar bzw. verschlossen sind, und wobei zumindest die vertikalen Rahmenschenkel (11,12) im Bereich ihrer Außenkanten abgeschrägt sind und dadurch eine Aufnahme (70) für abgekantete Ränder (34,41, 45) der Seitenwände (40,44) und der Tür (30) bilden,
dadurch gekennzeichnet,
daß die Eckverbinder (20) die Aufnahmen (70) der Rahmenschenkel (11, 18) überdecken und den Aufnahmen (70) zugekehrt mit Steckaufnahmen (21) bzw. Scharnierbolzen versehen sind,
daß die Türe (30) auf der Scharnierseite mit Scharnierbolzen bzw. Steckaufnahmen versehen ist, die in Steckaufnahmen (21) der Eckverbinder (20) einführbar bzw. eingeführt sind bzw. in die die Scharnierbolzen der Türe (30) einführbar bzw. eingeführt sind, und
daß die Türe (30) auf der Schließseite mit Schließbolzen (35) versehen ist, die mittels einer Schließeinrichtung (31) in Steckaufnahmen (21) der Eckverbinder (20) einführbar und wieder herausführbar sind.

2. Schaltschrank nach Anspruch 1,
dadurch gekennzeichnet,
daß die Rahmenschenkel (11,18) zwei senkrecht zueinander stehende Profilseiten (51,52) aufweisen, die Außenseiten des Rahmengestells (10) bilden, und daß diese Profilseiten (51,52) im Bereich der Außenkante über einen Verbindungs-Profilabschnitt (53) miteinander verbunden sind, der jeweils unter 135° zu diesen Profilseiten (51,52) steht.

3. Schaltschrank nach Anspruch 2,
dadurch gekennzeichnet,
daß die Profilseiten (51,52) über senkrecht zu ihren stehende Übergangs-Profilabschnitte (54,55) in den Verbindungsabschnitt (53) übergehen.

4. Schaltschrank nach einem der Ansprüche 1 bis 3,
dadurch gekennzeichnet,
daß die Eckverbinder (20) zwei senkrecht zueinander stehende Flächen (22,23) aufweisen, die Teile der Außenkanten des Rahmengestelles (10) bilden, und daß diese Flächen (22,23) bündig mit den Außenseiten der angrenzenden Seitenwände (40,45) und der geschlossenen Türe (30) abschließen.

5. Schaltschrank nach einem der Ansprüche 1 bis 4,
dadurch gekennzeichnet,
daß die Seitenwände (40,45), die Rückwand (46), das Bodenblech und das Deckblech mit den Eckverbindern (20) verschraubt sind, wobei die Flächen (21,22) der Eckverbinder (20) um aie DicKe der Wände und Bleche zurückgesetzte Anlageflächen (25,26) aufweisen.

6. SchaltschranK nach einem der Ansprüche 1 bis 5,
dadurch gekennzeichnet,
daß die Scharnierbolzen bzw. Schließbolzen (35) in an der Türe (30) angebrachten Lagerhülsen verstellbar geführt und/oder gehalten sind.

7. Schaltschrank nach einem der Ansprüche 1 bis 6,
dadurch gekennzeichnet,
daß die Scharnierbolzen aurcn Lagerhülsen der Türe (30) geführt in Steckaufnahmen (21) der Eckverbinder (20) eingeführt und darin durcn Paß- und/oder Preßsitz gehalten sind.

8. Schaltschrank nach einem der Ansprüche 1 bis 7,
dadurch gekennzeichnet,
daß die Seitenwände (40,45), die Rückwand (46), das Bodenblech und das Deckblech an den Rahmenschenkeln mit von außen nicht sichtbaren Befestigungsmitteln befestigt sind.

## Claims

1. Switchgear cabinet, having a framework (10) comprising frame members (11 to 18) and corner joints (20), the open sides of said framework being closable or closed by means of lateral walls (40,44), rear wall (46), bottom plate, top plate and at least one door (30), and wherein at least the vertical frame members (11,12) are chamfered in the region of their outer edges and thereby form a receiving means (70) for angled edges (34,41,45) of the lateral walls (40,44) and of the door (30), characterised in that the corner joints (20) cover the receiving means (70) of the frame members (11,18) and are provided with plug-in receivers (21) or hinge pins when facing the receiving means (70), in that the door (30) is provided on the hinge side with hinge pins or plug-in receivers, which are insertable or inserted in plug-in receivers (21) of the corner joints (20), or respectively the hinge pins of the door (30) are insertable or inserted in said plug-in receivers, and in that the door (30) is provided on the closing side with closing pins (35), which are insertable in plug-in receivers (21) of the corner joints (20), and removable therefrom again, by means of a closing arrangement (31).

2. Switchgear cabinet according to claim 1, characterised in that the frame members (11,18) have two section sides (51,52), which extend perpendicularly relative to each other and form external surfaces of the framework (10), and in that these section sides (51,52) are interconnected in the region of the outer edge via a connecting section portion (53) which, in each case, extends below 135° relative to these section sides (51,52).

3. Switchgear cabinet according to claim 2, characterised in that the section sides (51,52) extend into the connecting portion (53) via transitional section portions (54,55), which extend perpendicularly relative to said sides.

4. Switchgear cabinet according to one of claims 1 to 3, characterised in that the corner joints (20) have two faces (22,23), which extend perpendicularly relative to each other and form parts of the outer edges of the framework (10), and in that these faces (22,23) terminate flush with the external surfaces of the adjacent lateral walls (40,44) and the closed door (30).

5. Switchgea:r cabinet according to one of claims 1 to 4, characterised in that the lateral walls (40,44), the rear wall (46), the bottom plate and the top plate are screw-connected to the corner joints (20), the faces (22,23) of the corner joints (20) having abutment faces (25,26) which are set back by a spacing corresponding to the thickness of the walls and plates.

6. Switchgear cabinet according to one of claims 1 to 5, characterised in that the hinge pins or closing pins (35) are displaceably guided and/or retained in bearing sleeves mounted on the door (30).

7. Switchgear cabinet according to one of claims 1 to 6, characterised in that the hinge pins are guided by bearing sleeves of the door (30), inserted in plug-in receivers (21) of the corner joints (20) and retained therein by a snug fit and/or a press fit.

8. Switchgear cabinet according to one of claims 1 to 7, characterised in that the lateral walls (40,44), the rear wall (46), the bottom plate and the top plate are fastened to the frame members by fastening means which are not visible from the outside.

## Revendications

1. Armoire de distribution avec une ossature de cadre (10) composée de branches de cadre (11 à 18) et de cornières de jonction (20), armoire dont les côtés ouverts peuvent être ou sont fermés au moyen de parois latérales (40, 44), d'une paroi arrière (46), d'une tôle de fond, d'une tôle de recouvrement et d'au moins une porte (30), et où au moins les branches de cadre verticales (11, 12) sont biseautées dans la région de leurs arêtes extérieures et constituent de la sorte un logement récepteur (70) pour les bords coudés (34, 41, 45) des parois latérales (40, 44) et de la porte (30),
caractérisée
en ce que les cornières de jonction (20) recouvrent les logements récepteurs (70) des branches de cadre (11, 18) et sont, face aux logements récepteurs (70), dotés de récepteurs d'enfichage (21) ou de boulons de charnière,
en ce que la porte (30) est, côté charnière, dotée de boulons de charnière ou de récepteurs d'enfichage, qui peuvent être ou qui sont introduits dans des récepteurs d'enfichage (21) des charnières de jonction (20) ou dans lesquels peuvent être ou sont introduits les boulons de charnière de la porte, et en ce que la porte (30) est, côté fermeture, dotée de verrous ou de boulons de fermeture (35) qui au moyen d'un dispositif de fermeture (31) peuvent être introduits dans des récepteurs d'enfichage (21) des charnières de jonction (20) et qui peuvent également en être retirés.

2. Armoire de distribution suivant la revendication 1,
caractérisée
en ce que les branches de cadre (11, 18) présentent deux côtés de profilé (51, 52) perpendiculaires l'un à l'autre, qui constituent des faces extérieures de l'ossature de cadre (10) et
en ce que ces côtés de profilé (51, 52) sont, dans la région de l'arête extérieure, reliés par l'intermédiaire d'un tronçon de profilé de jonction (53), lequel forme un angle de 135° avec ces côtés de profilé (51, 52).

3. Armoire de distribution suivant la revendication 2, caractérisée
en ce que les côtés de profilé (51, 52) se raccordent au tronçon de jonction (53) par l'intermédiaire de tronçons de profilé de transition (54, 55) perpendiculaires aux côtés de profilé (51, 52).

4. Armoire de distribution suivant l'une quelconque des revendications de 1 à 3,
caractérisée
en ce que les cornières de jonction (20) présentent deux surfaces (22, 23) perpendiculaires l'une à l'autre qui constituent des portions des arêtes extérieures de l'ossature de cadre (10) et
en ce que ces surfaces (22, 23) se terminent à fleur des faces extérieures des parois latérales limitrophes (40, 45) et de la porte fermée (30).

5. Armoire de distribution suivant l'une quelconque des revendications de 1 à 4,
caractérisée
en ce que les parois extérieures (40, 45), la paroi arrière (46), la tôle de fond et la tôle de recouvrement sont réunies par vissage aux cornières de jonction (20), les surfaces (21, 22) des cornières de jonction (20) présentant des surfaces d'application (25, 26) décalées vers l'arrière de l'épaisseur des parois et des tôles.

6. Armoire de distribution suivant l'une quelconque des revendications de 1 à 5,
caractérisée
en ce que les boulons de charnière ou les verrous de fermeture (35) sont guidés et/ou maintenus de manière réglable dans des douilles de coussinet montées dans la porte (30).

7. Armoire de distribution suivant l'une quelconque des revendications de 1 à 6,
caractérisée
en ce que les boulons de charnière guidés dans des douilles de coussinet de la porte (30) sont introduits dans des récepteurs d'enfichage (21) des cornières de jonction (20) et y sont maintenus à siège précis et/ou à siège pressé.

8. Armoire de distribution suivant l'une quelconque des revendications de 1 à 7,
caractérisée
en ce que les parois extérieures (40, 45), la paroi arrière (46), la tôle de fond et la tôle de recouvrement sont fixées aux branches de cadre par des moyens de fixation non visibles depuis l'extérieur.
